# EUROPEAN PATENT APPLICATION

(11) **EP 0 848 233 A1**
(43) Date of publication of application: **17.06.1998**
(21) Application number: 96402730.4
(22) Date of filing: 13.12.1996
(51) Int. Cl.: G01D 3/08, G01R 1/18, B07C 1/02

(54) **A method to process optical information, a device realising the method and a postal automate including such a device**

(71) Applicant: ALCATEL ALSTHOM COMPAGNIE GENERALE D'ELECTRICITE, 75008 Paris (FR)
(72) Inventor: Loots, Ivan, 2640 Berchem (BE)
(74) Representative: Narmon, Gisèle

(57) **Abstract**

A method to process optical information (OI) which is created in an EMC sensitive area. The method includes :
- leading the optical information (OI) to an EMC safe area;
- converting the optical information (OI) to electrical information (EI) in the EMC safe area;
- electrical processing of the electrical information (EI) in the EMC safe area.

## Description

The present invention relates to a method to process optical information as described in the preamble of claim 1, and a device to process optical information realising the method as described in the preamble of claim 3, and a postal automate including such a device as described in the preamble of claim 10.

Such a method and device are already known in the art, e.g. from the international patent application with application number *PCT/US94/08641*, published under the patent cooporation treaty PCT with international publication number *WO 95/04257 entitled 'Improved optical displacement sensor'*. Therein optical information is created by moving progressively a plunger between an infrared light-emitting diode and a detector, i.e. an infrared phototransistor. Indeed, by moving progressively the plunger, the detected intensity of the infrared signal emitted by the light-emitting diode is decreased. This decrease is a measure for the displacement of the plunger whereby this information can be processed for different kind of application e.g. a robotic hand can sense if an item is slipping and in response tighten its grip on it. As it is mentioned on page 2 line 29 to 31 of the application, the optical displacement sensor is flexible for use in multiple environments. However, using this device in a very sensitive area for electromagnetic compatibility EMC would cause electrostatic discharge ESD on the EMC sensitive transducers and the electrical wires connected to the electronics would act as antenna.

Another example of creating optical information in an EMC sensitive area is a lightvalve used as a letter presence detector in an environment of postal automation. A light emitter diode directs a lightbeam towards a phototransistor whereby interruption of the lightbeam with a letter passing trough the lightbeam confirms the presence of the letter. Due to frictional electricity from belts and rollers of the postal automate, it becomes an EMC sensitive area which provides ESD on the sensitive transducers and, radiation and susceptibility of the electrical wires which are acting as antennas.

An object of the present invention is to provide a device to process optical information such as the above known ones but which are suited to process optical information which is created in an EMC sensitive area.

According to the invention, this object is achieved by the device to process optical information as described in claim 3 which is realising the method to process optical information as described in claim 1 and which is included in the postal automate described in claim 10.

Indeed, by leading the optical information which is created in the EMC sensitive area, from the EMC sensitive area to an EMC safe area and by converting the optical information to electrical information and by processing the electrical information only in this EMC safe area, no EMC sensitive devices are affected anymore since they are located in the EMC safe area. Also, no electrical wire of the device acts as antenna in the EMC sensitive area since electrical wires of the device only occur in the EMC safe area.

An application of the present invention is the improvement brought to a system to detect the presence and the kind of a poststamp on a letter which is also used, e.g. in this EMC sensitive area of postal automation. The optical information i.e. an image lift taken by an optical lens system of a camera is converted by this camera to electrical information. The electrical information is provided by means of an electrical wire to a printed circuit board PCB in order to be processed. It has to be remarked here that since the camera is an EMC shielded camera, i.e. protected against ESD, the camera is no EMC sensitive component and the problem does not occur at the camera but with the electrical wire which act as antenna. Following the method of the invention, the two functions of the camera are separated. The lens system is coupled to an optical cable including a predefined number of optical fibres which leads the optical information to an EMC safe area. The optical to electrical converter converting the optical information to electrical information and the PCB including electrical components to process the electrical information are located in the EMC safe area and no electrical wire acts as antenna anymore. This is described in claim 4.

In the application of the previous paragraph, the image lift was taken with the help of only natural light, however a much better quality is reached by lightening the letter and the poststamp. So, the optical information is created with the help of the optical light which is coming from a flicker free lamp included in the EMC safe area and which is leaded to the EMC sensitive area by means of a multicore optical cable, i.e. an optical cable including a predetermined number of optical fibres. A device to process optical information which is created in an EMC sensitive area according to the invention and whereby the optical information is created with an optical signal leaded by second optical leading means from the EMC safe area to the EMC sensitive area is described in claim 5 and is realising the method to process optical information as described in claim 2.

An application of the present invention is e.g. a bar code reader. Yet another application of the present invention is a presence detector as described in claim 6. Indeed, an optical lightvalve included in the EMC sensitive area directs the optical signal from the second optical leading means to the first optical leading means whereby interruption of the optical signal creates the optical information which is a measure for the presence detector.

A way of leading the optical signal or the optical information, respectively, in or out the EMC sensitive area is e.g. a system with lenses and mirrors but can also easily be realised by means of an optical cable. This is described in claim 7.

Taking back the application to the invention of the presence detector which includes an optical lightvalve it can be difficult to direct the optical signal from the second optical leading means to the first optical leading means, e.g. if the optical leading means are optical fibres, the optical fibres may have to be bended over an angle of approximately 90 degrees. In order to avoid this the optical lightvalve includes a first optical lens holder and a second optical lens holder. These lens holders are coupled to the first optical leading means and the second optical leading means without, e.g. bending these optical leading means, and are each including a system of a mirror and lenses which reflects and focuses the optical signal from the second optical leading means towards the first optical leading means. This is described in claim 8.

A possible use of the presence detector is described in claim 9. Herein, the presence detector is used in a postal automate whereby the interruption of the optical signal is provided by a letter passing through the optical signal. The presence of a letter is confirmed by processing the following electrical information. This electrical information can be used e.g. to trigger a camera which has to take an image lift of the letter.

As already explained above, postal automation is a very sensitive area to EMC because of frictional electricity from belts and rollers. Including a device to process optical information according the invention provides the advantage of e.g. the EMC sensitive components being protected against damage but also communicating by means of a mobile telephone near the postal automate becomes possible without providing electromagnetic interference. This is described in claim 10.

The above mentioned and other objects and features of the invention will become more apparent and the invention itself will be best understood by referring to the following description of an embodiment taken in conjunction with the accompanying drawings wherein:
Fig. 1 represents an helicopter view of a part of a postal automate including a presence detector according to the invention;
Fig. 2 represents a schematic representation of a cross-section of a presence detector in accordance with A-A in Fig. 1; and
Fig. 3 represents a longitudinal central cross-section of the first optical lens holder LH1 in Fig. 1 and 2.

A postal automate e.g. a mail handling machine with facing function which first faces the letters in the right way in order to be able to locate and to recognise the poststamp and which further on locates and recognises the addresses in order to be able to sort the letters in the right way includes different kind of optical devices. Such kind of optical devices are e.g. lightvalves to detect the presence of a letter which glides through the belts of the machine and camera's to take an image lift of the letter to recognise e.g. the kind of a poststamp or a part of the address. As already explained in the introductory part of this description a postal automate is an EMC sensitive area due to e.g. the motions of the belts and the rollers which provides frictional electricity. The frictional energy provides electrostatic discharge ESD on the sensitive transducers and radiation and susceptibility of the electrical wires. Since a postal automate includes easily about 400 optical devices, the latter ESD and radiation can be rather important and improvement thereof means a considerable improvement of the performance of the postal automate. The global working of the postal automate goes beyond the scope of the invention and the aim is the use of the present invention to improve the performance of the postal automate. Therefor only one device to process optical information following the present invention will be explained in this further description.

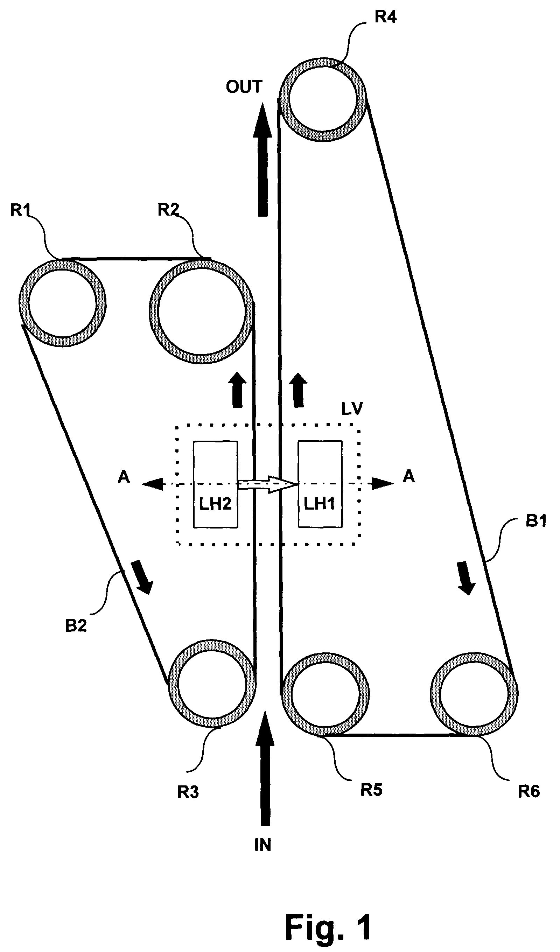

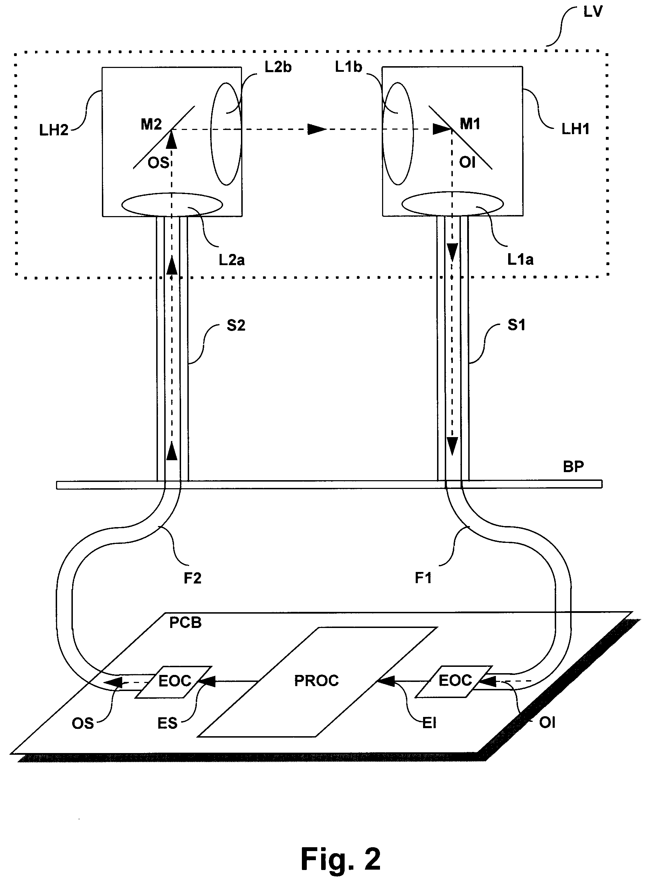

Referring to Fig. 1 an helicopter view of a part of a postal automate including a presence detector according to the present invention will be explained. The part of the postal automate includes rollers R1, R2, R3, R4 and R5 and belts B1 and B2 and a presence detector. Due to the helicopter view and a base plate BP (see Fig. 2) under this part of the postal automate, only part of the presence detector is visible. This part of the presence detector is an optical lightvalve LV which includes a first optical lens holder LH1 and a second optical lens holder LH2.

The working of this part of the postal automate including the optical lightvalve LV is explained as follows. Due to another part of the postal automate, which is not explained in detail the rollers R1, R2, R3, R4 and R5 are rotating. The rotating rollers R are driving the belts B1 and B2 to turn around the rollers R1, R2, R3, R4 and R5 in the direction of the short black arrows. Due to these turning belts B1 and B2 a letter (not shown) provided to the part of the postal automate at IN glides trough the belts B1 and B2 and leaves the part of the postal automate at OUT following the direction of the long black arrows.

The second optical lens holder LH2 directs an optical signal to the first optical lens holder LH1. This is shown on Fig. 1 with the white arrow. At the moment when the letter which is passing trough the optical signal, interrupts the optical signal, optical information is created and the presence of the letter is confirmed. This will be explained in further detail in the following paragraphs.

Referring to Fig. 2 a schematic representation of a cross-section of the presence detector in accordance with A-A in Fig. 1 is shown. First, a functional description of the blocks shown in Fig. 2 will be given. Based on this description, implementation of the functional blocks in Fig. 2 will be obvious to a person skilled in the art. In addition, the present invention, i.e. the device to process optical information and which is in this preferred embodiment a presence detector, will be described in further detail.

Due to the cross-section, the presence detector can be seen now in total. The presence detector includes the above mentioned optical lightvalve LV, a first and a second optical fibre F1 and F2, an optical to electrical converter OEC, an electrical to an optical converter EOC and electrical processing means PROC.

The optical lightvalve includes the above mentioned first and second optical lens holders LH1 and LH2. The first optical lens holder LH1 includes the lenses L1a and L1b and a mirror M1. The second optical lens holder LH2 includes the lenses L2a and L2b and also a mirror M2.

The first and second optical lens holders LH1 and LH2 are supported, respectively, by two lens supports S1 and S2 which are hollow stalks fixed on the base plate BP. The base plate BP is formed of aluminium which is an excellent conductor with a low resistance. It has to be remarked that although in this preferred embodiment an aluminium base plate is chosen, it will be obvious to a person skilled in the art that the invention is not restricted to the use of aluminium for the base plate BP.

Optical leading means, which are in this particular embodiment the first and the second optical fibre F1 and F2 are coupled to, respectively, the first optical lens holder LH1 and the second optical lens holder LH2 and are included, respectively, in the lens supports S1 and S2. The optical fibres F1 and F2 passes through the base plate BP in order to continue towards a printed circuit board PCB. The first optical fibre F1 is coupled to the optical electrical converter OEC which is mounted on the printed circuit board PCB and the second optical fibre F2 is coupled to the electrical optical converter EOC also mounted on the printed circuit board PCB. For the electrical to optical converter EOC the Toshiba Toslink transmitter is chosen and for the optical to electrical converter OEC the Toshiba Toslink receiver is chosen.

Furthermore, the electrical processing means PROC are also mounted on the printed circuit board PCB and are coupled between the optical to electrical converter OEC and the electrical to optical converter EOC. It has to be remarked that the detailed working of the electrical processing means PROC goes beyond the scope of the invention and is not going to be explained in detail.

The EMC sensitive area is the area above the base plate i.e. in the environment of the rollers R1, R2, R3, R4 and R5 and belts B1 and B2 (see Fig. 1) and includes the optical lightvalve LV and the two lens supports which are including the optical fibres. The EMC safe area is the area under the base plate which acts as buffer for the electrostatic discharges ESD coming of above from the EMC sensitive area. The base plate BS protects the EMC sensitive devices included in the EMC safe area i.e. electrical to optical converter EOC, optical to electrical converter OEC and the electrical processing means PROC. Although in this preferred embodiment the base plate BS is sufficiently to have an EMC safe area, it has to be remarked that still a better performance can be reached by clearly defining the EMC safe area as e.g. a metal box.

The presence detector works as follows. An electrical signal ES provided in the EMC sensitive area by the electrical processing means PROC to the electrical to optical converter EOC is converted into an optical signal OS. The second optical fibre F2 leads the optical signal OS from the EMC safe area to the EMC sensitive area i.e. to the second optical lens holder LH2. The optical signal OS is focused by the lens L2a, reflected by the mirror M2 and focused again by the lens L2b in order to be a concentrated parallel bundle directed to the first optical lens holder LH1.

As explained above in the part of the description belonging to Fig. 1 when the letter passes trough the optical signal OS, the optical signal OS is interrupted and creates the optical information OI which is a measure for the presence detector, i.e. confirmation of the presence of the letter.

The first optical lens holder LH1 collects the optical information OI with the lens L1b which focuses the optical information OI. The optical information is reflected by the mirror M1 and focused again by the lens L1a in order to be directed to and collected by the first optical fibre F1. The first optical fibre F1 leads the optical information OI from the EMC sensitive area to the EMC safe area i.e. to the optical electrical converter OEC in order to be converted into electrical information EI. The electrical information EI is processed by the electrical processing means PROC in the EMC safe area and is used e.g. to trigger a camera which has to take an image lift of the letter which just passed the optical lightvalve LV.

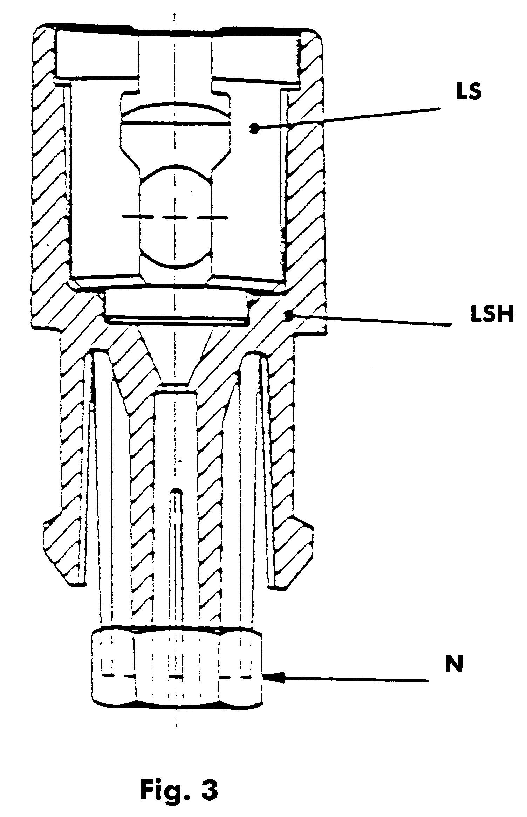

Fig. 3 represents a longitudinal central cross-section of the first optical lens holder LH1. The first optical lens holder LH1 includes :
- a lens system LS which includes the mirror M1 and the lenses L1a and L1b and which is made of Styrol Acryl Nytryl (SAN), a copolymer in order to ensure the focusing and mirroring functions;
- a lens system holder LSH which includes an indented round inlet included to slide in an optical fibre e.g. the first optical fibre F1; and
- a nut N which closes the indents when screwed down the inlet and which thereby fastens the first optical fibre F1 to the optical lens holder LH1. It has to be remarked that the second optical lens holder LH2 is identical to the first optical lens holder LH1 and is mounted opposite to the first optical lens holder LH1.

It has to be remarked that the application of the invention is not limited to the type of lensholders as described in Fig. 3, but it is evident to a person skilled in the art that other types of lensholder can be used to direct the optical signal OS from the second optical leading means to the first optical leading means.

Referring back to the postal automate, the present invention is used for all included devices to process optical information. In addition, the other included printed circuit boards similar to the printed circuit board PCB of Fig. 2 and this printed circuit board are coupled to each other via a daisy chained ring network. This ring network is coupled to a central processor in order to control the global working of the postal automate which has a significantly improved performance.

It has to be remarked that in this preferred embodiment all EMC sensitive components and all electrical wires are included in the EMC safe area. However, referring e.g. to the electrical to optical converter EOC, which is a less EMC sensitive component than the optical electrical converter OEC, the electrical to optical converter EOC could also remain in the EMC sensitive area. Indeed, the electrical to optical converter EOC can also be protected by encapsulating it in a metal or plastic package whereby the electrical to optical converter EOC becomes an EMC shielded component. This solution has however the disadvantages that such a package suffers often of side leakage and that the electrical signal provided to the electrical to the optical converter EOC will have to be brought into the EMC sensitive area which creates again the antenna effect of the electrical wire.

Moreover, it should be noted that, although the above described postal automate is a postal automate with an EMC safe area under the base plate BS of the postal automate, the application of the present invention is not reduced to such kind of postal automates. Small modifications, evident to a person skilled in the art, may be applied to the above described embodiment to adapt the postal automate into a postal automate with an EMC safe area located at another part of the postal automate. For instance, a metal box placed next to the postal automate.

Finally, it has to be remarked that, although the above described device to process optical information is a presence detector used in a postal automate, the application of the present invention is not reduced to this field of presence detector and postal automate. Indeed, the above described invention may be applied to other devices which have to process optical information which is created in technical fields where due to e.g. high voltages, rotating units or rubbing parts frictional electricity and electrostatic discharges are present.

While the principles of the invention have been described above in connection with specific apparatus, it is to be clearly understood that this description is made only by way of example and not as a limitation on the scope of the invention.

## Claims

1. A method to process optical information (OI) which is created in an EMC sensitive area, **characterised** in that said method includes :
- leading said optical information (OI) to an EMC safe area;
- converting said optical information (OI) to electrical information (EI) in said EMC safe area;
- electrical processing of said electrical information (EI) in said EMC safe area;

2. The method to process optical information (OI) according to claim 1, characterised in that said method further includes :
- converting an electrical signal (ES) into an optical signal (OS) in said EMC safe area;
- leading said optical signal (OS) from said EMC safe area to said EMC sensitive area;
- creating said optical information (OI) with said optical signal (OS) in said EMC sensitive area.

3. A device to process optical information (OI) which is created in an EMC sensitive area, **characterised** in that said device includes :
- first optical leading means to lead said optical information (OI) to an EMC safe area;
- an optical to electrical converter (OEC) included in said EMC safe area to convert said optical information (OI) to electrical information (EI); and
- electrical processing means (PROC) included in said EMC safe area to process said electrical information (EI).

4. A device to process optical information (OI) according to claim 3, characterised in that said device further includes an optical lens system to take an image lift which thereby creates said optical information (OI) and which is coupled to said first optical leading means which is an optical cable.

5. The device to process optical information (OI) according to claim 3, characterised in that said device further includes :
- an electrical to optical converter (EOC) included in said EMC safe area to convert an electrical signal (ES) into an optical signal (OS);
- second optical leading means to lead said optical signal (OS) from said EMC safe area to said EMC sensitive area; and
- creating means included in said EMC sensitive area to create with said optical signal (OS) said optical information (OI).

6. The device to process optical information (OI) according to claim 5, characterised in that said device is a presence detector and said creating means is an optical lightvalve (LV) included to direct said optical signal (OS) from said second optical leading means to said first optical leading means and whereby interruption of said optical signal (OS) creates said optical information (OI) which is a measure for said presence detector.

7. The device to process optical information (OI) according to claim 5, characterised in that said first optical leading means is a first optical cable including at least one first optical fibre (F1) and said second optical leading means is a second optical cable including at least one second optical fibre (F2).

8. The device to process optical information (OI) according to claim 6, characterised in that said optical lightvalve (LV) includes a first optical lens holder (LH1) coupled to said first optical leading means and a second optical lens holder (LH2) coupled to said second optical leading means, said first optical lens holder (LH1) and said second optical lens holder (LH2) included to direct said optical signal (OS) from said second optical leading means to said first optical leading means.

9. The device to process optical information (OI) according to claim 6, characterised in that said presence detector is used in a postal automate and whereby said interruption is provided by a letter passing through said optical signal (OS).

10. A postal automate characterised in that said postal automate includes at least one device to process optical information (OI) as described in claim 3.
